(19) Europäisches Patentamt
European Patent Office
Office européen des brevets

(11) EP 4 546 604 A1

(12) EUROPEAN PATENT APPLICATION

(43) Date of publication:
30.04.2025 Bulletin 2025/18

(51) International Patent Classification (IPC):
H02J 7/00 $^{(2006.01)}$

(21) Application number: 24200496.8

(52) Cooperative Patent Classification (CPC):
H02J 7/007194; H02J 7/0047; H02J 7/0048

(22) Date of filing: 16.09.2024

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.10.2023 CN 202311412495

(71) Applicant: Getac Technology Corporation
New Taipei City 221009 (TW)

(72) Inventors:
• YU, Chien-Pang
11568 Taipei City (TW)
• CHEN, Li-Shing
11568 Taipei City (TW)

(74) Representative: Viering, Jentschura & Partner
mbB
Patent- und Rechtsanwälte
Am Brauhaus 8
01099 Dresden (DE)

(54) BATTERY DETECTION CIRCUIT AND BATTERY DETECTION METHOD

(57) A battery detection circuit (1) and a battery detection method are provided. The battery detection circuit (1) includes battery gauge circuits (10-1, 10-2, 10-3) and a processing circuit (12). The battery gauge circuits (10-1, 10-2, 10-3) read battery information of batteries (3), and the battery information at least includes a current battery capacity, a current temperature and a current cell voltage. The processing circuit (12) receives and processes the battery information, and performs: determining whether a battery temperature of any one of the batteries (3) is greater than a designated temperature; if negative, determining whether the current cell voltage of any one of the batteries (3) is lower than a designated voltage, and if affirmative, adjusting the corresponding current battery capacity to generate a reported battery capacity.

FIG. 1

## Description

## FIELD OF THE DISCLOSURE

The present invention relates to a circuit and a method, and more particularly to a battery detection circuit and a battery detection method.

## BACKGROUND OF THE DISCLOSURE

Existing electronic products such as laptops or tablets may only be operated in limited areas or environments since there are no relevant protection mechanisms designed for harsh environments.

For example, when such electronic products are used in a low-temperature environment, there may be drastic changes in their battery power (or even sudden drops to 0%). This can cause an operating system of the electronic products to automatically enter into sleep mode or shut down directly, which can greatly inconvenience the user if data is not backed up in advance.

On the other hand, when such electronic products are stored in a high-humidity environment, excessive humidity may easily cause condensation on certain components such as a printed circuit board thereof, leading to short-circuiting of the batteries in these products or even fire hazard.

## SUMMARY OF THE DISCLOSURE

In response to the above-referenced technical inadequacies, the present invention provides a battery detection circuit and a battery detection method capable of being used in harsh environments.

In one aspect, the present invention provides a battery detection circuit suitable for an electronic device with a multi-battery architecture, and the battery detection circuit includes a plurality of battery gauge circuits and a processing circuit. The battery gauge circuits are respectively configured to read battery information of a plurality of batteries, and the battery information at least includes a current battery capacity, a current temperature and a current cell voltage. The processing circuit is electrically connected to the battery gauge circuits, and is configured to receive and process the battery information of the batteries, and to perform the following: determining whether or not a battery temperature of any one of the plurality of batteries is greater than a designated temperature; determining whether the current cell voltage of any one of the plurality of batteries is lower than a designated voltage in response to determining that the battery temperature of any one of the plurality of batteries is not greater than the designated temperature; and adjusting the corresponding current battery capacity to generate a reported battery capacity in response to determining that the current cell voltage of any one of the plurality of batteries is lower than the designated voltage.

In another aspect, the present invention provides a battery detection method suitable for an electronic device with a multi-battery architecture, and the battery detection method includes: configuring a plurality of battery gauge circuits to respectively read battery information of a plurality of batteries, in which the battery information at least includes a current battery capacity, a current temperature and a current cell voltage; configuring a processing circuit to receive and process the battery information of the plurality of batteries, and to perform the following: determining whether or not a battery temperature of any one of the plurality of batteries is greater than a designated temperature; determining whether the current cell voltage of any one of the plurality of batteries is lower than a designated voltage in response to determining that the battery temperature of any one of the plurality of batteries is not greater than the designated temperature; and adjusting the corresponding current battery capacity to generate a reported battery capacity in response to determining that the current cell voltage of any one of the plurality of batteries is lower than the designated voltage.

These and other aspects of the present invention will become apparent from the following description of the embodiment taken in conjunction with the following drawings and their captions, although variations and modifications therein may be affected without departing from the spirit and scope of the novel concepts of the invention.

## BRIEF DESCRIPTION OF THE DRAWINGS

The described embodiments may be better understood by reference to the following description and the accompanying drawings, in which:

FIG. 1 is a functional block diagram of a battery detection circuit according to one embodiment of the present invention;
FIG. 2 is a first flowchart of a battery detection method according to one embodiment of the present invention;
FIG. 3 is a second flowchart of the battery detection method according to one embodiment of the present invention;
FIG. 4 is a third flowchart of the battery detection method according to one embodiment of the present invention;
FIG. 5 is a schematic diagram illustrating changes in a battery capacity over time of an electronic device in a low-temperature state without implementing the battery detection circuit and the battery detection method of the present invention;
FIG. 6 is a schematic diagram illustrating changes in the battery capacity over time of an electronic device in a low-temperature state after implementing the battery detection circuit and the battery detection method of the present invention; and
FIG. 7 is a fourth flowchart of the battery detection method according to one embodiment of the present invention.

## DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

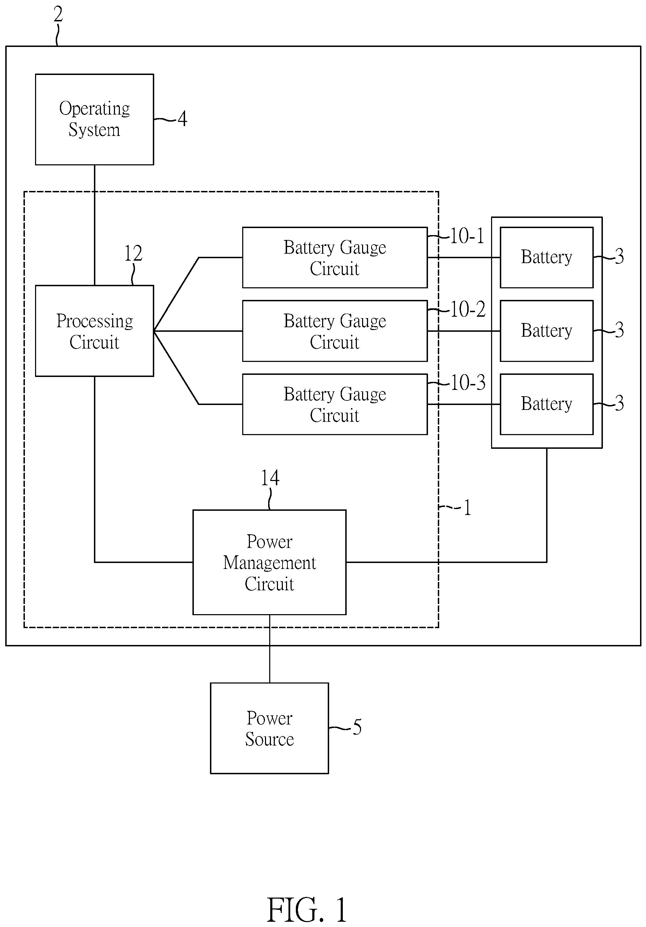

Referring to FIG. 1, one embodiment of the present invention provides a battery detection circuit 1 suitable for an electronic device 2 with a multi-battery architecture. The electronic device 2 can be, for example, a portable electronic product such as a notebook computer or a tablet computer, but the present invention is not limited thereto. An operating system 4 is executed by the electronic device 2.

The battery detection circuit 1 can include a plurality of battery gauge circuits (e.g., battery gauge circuits 10-1, 10-2, 10-3) and a processing circuit 12. The battery gauge circuits are configured to read battery information of the plurality of batteries. In the battery detection circuit 1, the processing circuit 12 can include, for example, one or more processors and a memory electrically connected thereto. The processing circuit 12 is electrically connected to the battery gauge circuits 10-1, 10-2, and 10-3. Each of the battery gauge circuits 10-1, 10-2, 10-3 can be, for example, an isolated integrated circuit, or implemented in firmware for a programmable microprocessor.

In one embodiment of the present invention, the battery gauge circuits 10-1, 10-2, and 10-3 can be used to monitor a current cell voltage, charging/discharging currents and a battery temperature of each battery 3, and estimate the battery capacity, such as a state of charge (SOC) and a fully charged capacity (FCC) of each battery 3. Taking the battery 3 with cells connected in a combination of series and parallel connections, such as 3S2P as an example, the battery gauge circuits 10-1, 10-2, and 10-3 can read a current battery capacity, a current temperature, and a current cell voltage of the battery 3 (for example, as having three voltages).

The battery gauge circuits 10-1, 10-2, and 10-3 can estimate a state of charge (SOC) of each battery 3 through an open circuit voltage (OCV) algorithm or a coulomb counter. The open circuit voltage algorithm can be performed by mapping an open circuit voltage to an SOC look-up table, and a general definition of the open circuit voltage is only if the battery has been in a relaxation phase for approximately more than 30 minutes. The coulomb counter operation theory connects a sense resistor in the charge/discharge path of battery, and an analog to digital converter (ADC) measures a voltage on the sense resistor and then transfers the voltage into a current value when the battery is in a charging or discharging state. A real time counter (RTC) is then used to integrate the current value with time to accurately calculate the SOC during charge or discharge in real time. Through the above method, a remaining capacity (RMC) and the FCC of each battery 3 can be calculated.

The relationship between SOC, RMC and FCC can be expressed by the following formula (1):

$$SOC = RMC/FCC * 100\% \ldots Formula\ (1).$$

For example, if the RMC is 4000 mAh and the FCC is 5000 mAh, the SOC can be calculated to be 4000/5000 * 100% = 80%.

Therefore, the battery information can at least include a current battery capacity, a current temperature, and a current cell voltage of each battery 3. Generally speaking, the operating system 4 can report the current battery capacity, the current temperature, and the current cell voltage of each battery 3 through the battery gauge circuits 10-1, 10-2, and 10-3. The processing circuit 12 is electrically connected to the battery gauge circuits 10-1, 10-2, and 10-3, and is configured to receive and process the battery information of the batteries 3.

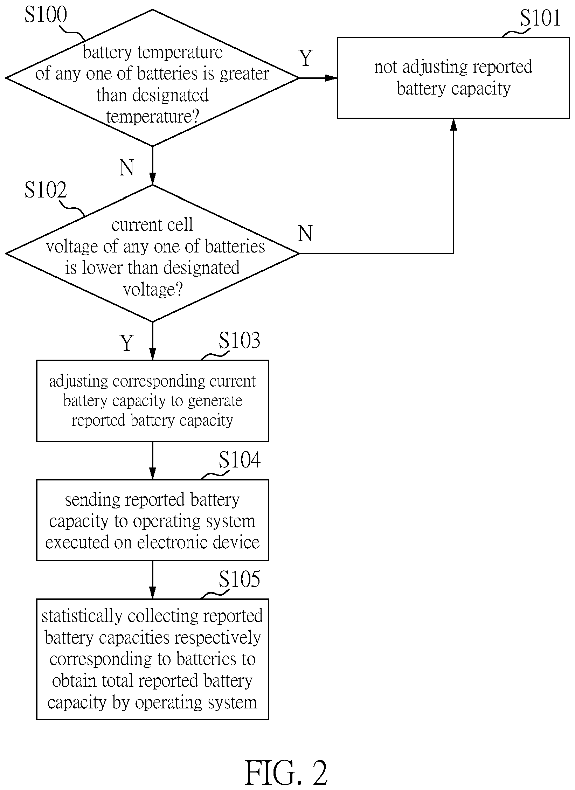

FIG. 2 is a first flowchart of a battery detection method according to one embodiment of the present invention. Referring to FIG. 2, the present invention further provides a battery detection method, which is suitable for the aforementioned electronic device 2 with the multi-battery architecture. The battery detection method includes configuring the processing circuit 12 to perform the following:

Step S 100: determining whether or not a battery temperature of any one of the plurality of batteries is greater than a designated temperature. In step S 100, if it is determined that the battery temperature is not greater than the designated temperature, the electronic device 2 may be in a low temperature state, and the battery capacity may change drastically or may suddenly drop to 0%. Therefore, it may be necessary to perform adjustments to the battery capacity. The designated temperature is, for example, within a range from -5°C to -15°C. Preferably, the designated temperature ranges from -8°C to -12°C, for example.

In response to determining that the battery temperature of any one of the batteries is greater than the designated temperature, the method proceeds to step S101: not adjusting a reported battery capacity.

In response to determining that the battery temperature of each of the batteries is not greater than the designated temperature, the method proceeds to step S102: determining whether or not a current cell voltage of any one of the plurality of batteries is lower than a designated voltage. Specifically, if the current cell voltage of any one of the batteries 3 is lower than the designated voltage (for example, 3V), an overall battery capacity may change drastically due to low temperature.

In response to determining that the current cell voltage of any one of the batteries 3 is lower than the designated voltage, the method proceeds to step S 103: adjusting the corresponding current battery capacity to generate a reported battery capacity. In this step, the current battery capacity can be periodically reduced by a predetermined proportion according to a predetermined time for generating a reported battery capacity. For example, the reported battery power can be adjusted by reducing the reported battery capacity by 1% every 20 seconds, thereby avoiding drastic changes in the overall battery capacity due to the low temperature.

In response to determining in step S 102 that the current cell voltage of each battery 3 is not lower than the designated voltage, the method proceeds to step S101: not adjusting the reported battery capacity.

Step S 104: sending the reported battery capacity to the operating system executed on the electronic device.

Step S105: statistically collecting, by the operating system, a plurality of the reported battery capacities respectively corresponding to the batteries to obtain a total reported battery capacity.

Optionally, in step S 105, in response to the total reported battery capacity being lower than a low battery standard, the operating system 4 can generate a low battery warning through the electronic device 2. For example, a warning message can be provided through a display of the electronic device 2, or a warning sound can be emitted through a built-in speaker of the electronic device 2, thereby reminding a user to backup any important data currently in use or to turn off the electronic device 2 through a normal shutdown procedure.

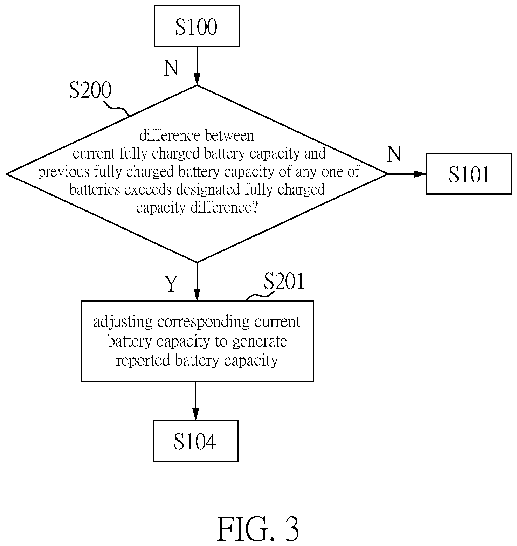

Reference is made to FIG. 3, which is a second flowchart of the battery detection method according to one embodiment of the present invention. In addition to the above adjustment manners, the battery detection method of the present invention can also monitor the detected fully charged capacity, and be involved in the adjustment of the reported battery capacity when a variation of the fully charged capacity meets a specific condition.

Continuing with step S 100, in response to determining in step S 100 that the battery temperature of each of the batteries 3 is less than or equal to the designated temperature, the method then proceeds to step S200: determining whether or not a difference between a current fully charged battery capacity and a previous fully charged battery capacity of any one of the batteries exceeds a designated fully charged capacity difference. It should be noted that in this step, the current fully charged battery capacity and the previous fully charged battery capacity are both fully charged capacities (FCC).

For example, the battery gauge circuits 10-1, 10-2, and 10-3 can periodically detect and record the FCC. If it is determined in step S200 that the difference between the current fully charged battery capacity and the previous fully charged battery capacity of any one of the batteries 3 exceeds the designated fully charged capacity difference, for example, 150 mAh, the method proceeds to step S201: adjusting the corresponding current battery capacity to generate the reported battery capacity. The method then proceeds to step S104. Similarly, the current battery capacity can be periodically reduced by a predetermined proportion according to the predetermined time to generate the reported battery capacity, thereby avoiding drastic changes in the overall battery capacity due to low temperature.

If it is determined in step S200 that the difference between the current fully charged battery capacity and the previous fully charged battery capacity of each battery 3 does not exceed the designated fully charged difference, the method proceeds to step S101: not adjusting the reported battery capacity.

Therefore, by detecting the FCC of each battery 3, it is possible to intervene in the adjustment of the reported battery capacity when the FCC is significantly affected by low temperature.

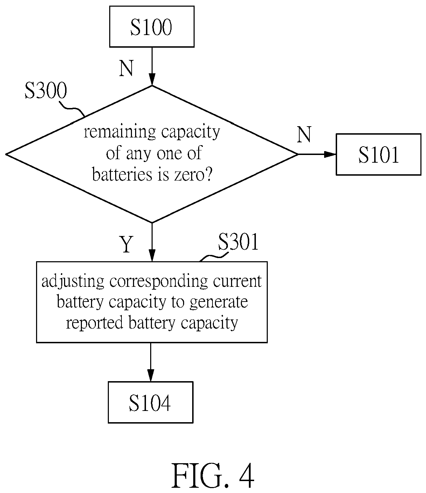

Reference is made to FIG. 4, which is a third flowchart of the battery detection method according to one embodiment of the present invention. In addition to the above adjustment manners, the battery detection method of the present invention can also monitor the remaining capacity, and be involved in the adjustment of the reported battery capacity when a variation of the remaining capacity meets a specific condition.

Continuing with step S100, if it is determined in step S 100 that the battery temperature of each of the batteries 3 is less than or equal to the designated temperature, then the method proceeds to step S300: determining whether or not the remaining capacity of any one of the batteries is zero.

For example, the battery gauge circuits 10-1, 10-2, and 10-3 can periodically detect and record the remaining battery capacity (RMC). If it is determined in step S300 that the remaining power of any battery 3 is zero, it means that the battery is affected by low temperature and the remaining capacity has changed drastically. The method then proceeds to step S301: adjusting the corresponding current battery capacity to generate the reported battery capacity. The method then proceeds to step S104. Similarly, the current battery capacity can be periodically reduced by a predetermined proportion according to the predetermined time to generate the reported battery capacity, thereby avoiding drastic changes in the overall battery capacity due to the remaining power of one of the batteries 3 reaching zero. That is, if it is determined in step S300 that the remaining power of each battery 3 is not zero, the method can proceeds to step S101.

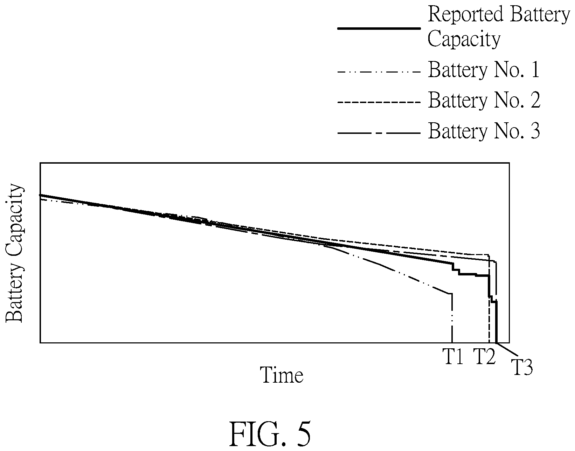

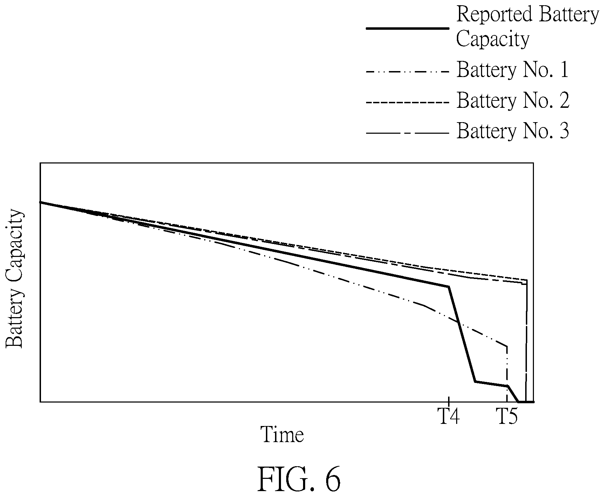

Reference is made to FIGS. 5 and 6, in which FIG. 5 is a schematic diagram illustrating changes in a battery capacity over time of an electronic device in a low-temperature state without implementing the battery detection circuit and the battery detection method of the present invention, and FIG. 6 is a schematic diagram illustrating changes in the battery capacity over time of an electronic device in a low-temperature state after implementing the battery detection circuit and the battery detection method of the present invention.

As shown in FIG. 5, when the battery detection circuit and battery detection method of the present invention are not implemented, the reported battery capacity displayed by the operating system 4 of the electronic device 2 changes drastically at times T1, T2, and T3. At time T1, the reported battery capacity is mainly affected by an instantaneous capacity drop of a first battery (No. 1) to zero. At time T2, the reported battery capacity is mainly affected by an instantaneous capacity drop of a second battery (No. 2) to zero. At time T3, the reported battery capacity is mainly affected by an instantaneous capacity drop of a third battery (No. 3) to zero. Therefore, it can be clearly understood that the user has encountered a situation where the battery capacity changes drastically at time T 1 and time T2, or even encountered a situation where the battery capacity suddenly dropped to 0% at time T3.

As shown in FIG. 6, after implementing the battery detection circuit and battery detection method of the present invention, at time T4, since a current cell voltage of the first battery (No. 1) is lower than the designated voltage, which meets a condition that the current cell voltage of any one of the batteries is lower than the designated voltage, the processing circuit 12 consequently intervenes in adjustment of the reported battery capacity displayed by the operating system 4 of the electronic device 2, such that the reported battery capacity can gradually decrease rather than drop sharply. At time T5, since the remaining capacity of the first battery reaches zero, which meets a condition that the remaining capacity of any one of the batteries is zero, the processing circuit 12 continues to adjust the reported battery capacity such that the reported battery capacity can gradually decrease rather than drop sharply. Therefore, the user can be prevented from encountering drastic changes or sudden drops to 0% in the battery capacity.

Reference is further made to FIG. 1. In some embodiments, the battery gauge circuits 10-1, 10-2, and 10-3 can also be used to report a present battery current of each battery 3, and the battery detection circuit 1 further includes a power management circuit 14 that is configured to detect a power status of the electronic device 2 and a connection status of a power source 5. For example, the power management circuit 14 can include one or more of a power supply, a charger, and a power converter, and the power source 5 can be, for example, an adapter for providing AC power.

Specifically, when the electronic device 2 is stored, the electronic device 2 is usually turned off and the power source 5 is removed. However, when the environment in which the electronic device 2 is stored is relatively harsh, a protection mechanism needs to be designed to prevent short circuit or combustion events that may occur during storage.

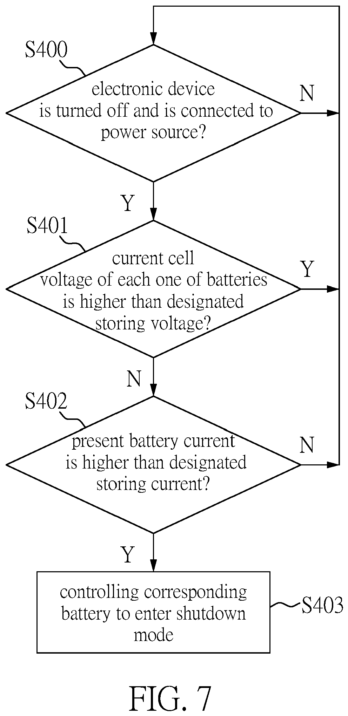

Therefore, reference is made to FIG. 7, which is a fourth flowchart of the battery detection method according to one embodiment of the present invention. The battery detection method further includes configuring the processing circuit 10 to perform the following:

Step S400: determining whether or not the electronic device is turned off and is connected to the power source. In response to determining that the electronic device is not turned off or is not connected to the power source, step S400 is performed repeatedly.

In response to determining that the electronic device 2 is turned off and the power source 5 is not connected in step S400, the method proceeds to step S401: determining whether or not the current cell voltage of each one of batteries is higher than a designated storing voltage. The designated storing voltage can be, for example, 9V.

If it is determined in step S401 that the current cell voltage of each battery is higher than the designated storing voltage, it means that no voltage drop has occurred, and the method returns to step S400 to repeatedly detect whether or not the electronic device 2 is in the storage state.

If it is determined in step S401 that the current cell voltage of any one of batteries 3 is not higher than the designated storing voltage, step S402 is performed for the battery 3 having the current cell voltage that is not higher than the designated storing voltage: determining whether or not the present battery current is higher than a designated storing current, for example, 1 A.

In response to determining that the present battery current is not higher than the designated storing current in step S402, the method returns to step S400 to repeatedly detect whether or not the electronic device 2 is in the storage state.

In response to determining that the present battery current is higher than the designated storing current in step S402, the method proceeds to step S403: controlling the corresponding battery to enter a shutdown mode. In step S403, the designated storing voltage and designated storing current are designed to detect whether or not the current cell voltage of each battery 3 has a voltage drop and a large current.

When a system of the electronic device 2 is turned off and the power source, such as an alternating current (AC) adapter, is not connected, if an abnormality and a short-circuit event occurs in the system which causes a voltage drop and large current in the battery voltage, the processing circuit (microprocessor) can detect the battery voltage and the battery current. When the battery voltage is less than the designated voltage (for example, 9V) and the battery discharge current is greater than the designated current (1A), it is determined that a short-circuit event has occurred, and the battery can be controlled to immediately enter the shutdown mode such that the batteries 3 will no longer output voltage, or the current of each battery 3 can be decreased to about 1 mA or less, thereby preventing the battery 3 from bursting into flames.

In conclusion, in the battery detection circuit and battery detection method provided by the present invention, the battery voltage, fully charged capacity and/or remaining capacity can be monitored, respectively, and the adjustment of the reported battery capacity can be made when a specific condition is met, thereby preventing users from encountering drastic changes in the battery capacity at low temperature, or preventing the electronic device from automatically shutting down or entering sleep mode when the battery capacity drops to 0%. The users are thereby allowed to back up their data and perform a normal shut down of the electronic device in time.

In addition, in the battery detection circuit and battery detection method provided by the present invention, a protection mechanism is further designed for the storage state. If the short-circuit event occurs due to harsh environments, the battery will be controlled to immediately enter the shutdown mode to prevent the battery from bursting into flames.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated. Alternative embodiments will become apparent to those skilled in the art to which the present invention pertains without departing from its spirit and scope.

## Claims

1. A battery detection circuit (1), **characterized by** comprising:

   a plurality of battery gauge circuits (10-1, 10-2, 10-3) configured to read battery information of a plurality of batteries (3), wherein the battery information at least comprises a current battery capacity, a current temperature and a current cell voltage;
   a processing circuit (12) electrically connected to the plurality of battery gauge circuits (10-1, 10-2, 10-3), wherein the processing circuit (12) is configured to receive and process the battery information of the plurality of batteries (3), and to perform the following:

      determining whether a battery temperature of any one of the plurality of batteries (3) is greater than a designated temperature;
      determining whether the current cell voltage of any one of the plurality of batteries (3) is lower than a designated voltage in response to determining that the battery temperature of each of the plurality of batteries (3) is not greater than the designated temperature; and
      adjusting a corresponding current battery capacity to generate a reported battery capacity in response to determining that the current cell voltage of any one of the plurality of batteries (3) is lower than the designated voltage.

2. The battery detection circuit (1) according to claim 1, wherein the designated temperature ranges from -5°C to -15°C.

3. The battery detection circuit (1) according to claim 1, wherein the adjusting the corresponding current battery capacity to generate the reported battery capacity comprises periodically reducing the current battery capacity by a predetermined proportion according to a predetermined time to generate the reported battery capacity.

4. The battery detection circuit (1) according to claim 1, wherein the processing circuit (12) is further configured to perform the following:

> determining whether a difference between a current fully charged battery capacity and a previous fully charged battery capacity of any one of the plurality of batteries (3) exceeds a designated fully charged capacity difference in response to determining that the battery temperature of each of the plurality of batteries (3) is less than or equal to the designated temperature; and
> adjusting the corresponding current battery capacity to generate the reported battery capacity in response to determining that the difference between the current fully charged battery capacity and the previous fully charged battery capacity of any one of the plurality of batteries (3) exceeds the designated fully charged capacity difference.

5. The battery detection circuit (1) according to claim 1, wherein the processing circuit (12) is further configured to perform the following:

> determining whether a remaining battery capacity of any one of the plurality of batteries (3) is zero in response to determining that the battery temperature of each of the plurality of batteries (3) is less than or equal to the designated temperature; and
> adjusting the corresponding current battery capacity to generate the reported battery capacity in response to determining that the remaining battery capacity of any one of the plurality of batteries (3) is zero.

6. The battery detection circuit (1) according to claim 1, wherein the processing circuit (12) is further configured to transmit the reported battery capacity to an operating system (4) executed by an electronic device (2), and the operating system (4) statistically collects a plurality of the reported battery capacities respectively corresponding to the plurality of batteries (3) to obtain a total reported battery capacity.

7. The battery detection circuit (1) of claim 6, wherein the operating system (4) generates a low battery warning through the electronic device (2) in response to the total reported battery capacity being lower than a low battery standard.

8. The battery detection circuit (1) according to claim 1, further comprising a power management circuit (14) configured to detect a power status of an electronic device (2) and a connection status of a power source (5).

9. The battery detection circuit (1) of claim 8, wherein the battery information further comprises a present battery current, the processing circuit (12) is electrically connected to the power management circuit (14) and is further configured to:

> determine whether the electronic device (2) is turned off and is connected to the power source (5);
> determine whether the current cell voltage of each one of the plurality of batteries (3) is higher than a designated storing voltage in response to determining that the electronic device (2) is turned off and the power source (5) is not connected;
> determine whether the present battery current of a battery being not higher than the designated storing voltage is higher than a designated storing current in response to determining that the current cell voltage of any one of the plurality of batteries (3) is not higher than the designated storing voltage; and
> controlling the battery to enter a shutdown mode in response to determining that the present battery current of the battery being not higher than the designated storing voltage is higher than the designated storing current.

10. A battery detection method, **characterized by** comprising:

> configuring a plurality of battery gauge circuits (10-1, 10-2, 10-3) to respectively read battery information of a plurality of batteries (3), wherein the battery information at least comprises a current battery capacity, a current temperature and a current cell voltage;
> configuring a processing circuit (12) to receive and process the battery information of the plurality of batteries (3), and to perform the following:
>
>> determining whether a battery temperature of any one of the plurality of batteries (3) is greater than a designated temperature;
>> determining whether the current cell voltage of any one of the plurality of batteries (3) is lower than a designated voltage in response to determining that the battery temperature of each of the plurality of batteries (3) is not greater than the designated temperature; and
>> adjusting a corresponding current battery capacity to generate a reported battery capacity in response to determining that the current cell voltage of any one of the plurality of batteries (3) is lower than the designated voltage.

11. The battery detection method according to claim 10, wherein the designated temperature ranges from -5°C to -15°C, and adjusting the corresponding current battery capacity to generate the reported battery capacity comprises periodically reducing the current battery capacity by a predetermined proportion according to a predetermined time to generate the reported battery capacity.

12. The battery detection method according to claim 10, further comprising: configuring the processing circuit (12) to perform:

determining whether a difference between a current fully charged battery capacity and a previous fully charged battery capacity of any one of the plurality of batteries (3) exceeds a designated fully charged capacity difference in response to determining that the battery temperature of each of the plurality of batteries (3) is less than or equal to the designated temperature;

adjusting the corresponding current battery capacity to generate the reported battery capacity in response to determining that the difference between the current fully charged battery capacity and the previous fully charged battery capacity of any one of the plurality of batteries (3) exceeds the designated fully charged capacity difference;

determining whether a remaining battery capacity of any one of the plurality of batteries (3) is zero in response to determining that the battery temperature of each of the plurality of batteries (3) is less than or equal to the designated temperature; and

adjusting the corresponding current battery capacity to generate the reported battery capacity in response to determining that the remaining battery capacity of any one of the plurality of batteries (3) is zero.

13. The battery detection method according to claim 10, further comprising: configuring the processing circuit (12) to transmit the reported battery capacity to an operating system (4) executed by an electronic device (2), and the operating system (4) statistically collects a plurality of the reported battery capacities respectively corresponding to the plurality of batteries (3) to obtain a total reported battery capacity, wherein the operating system (4) generates a low battery warning through the electronic device (2) in response to the total reported battery capacity being lower than a low battery standard.

14. The battery detection method according to claim 10, further comprising: configuring a power management circuit (14) of an electronic device (2) to detect a power status of the electronic device (2) and a connection status of a power source (5).

15. The battery detection method according to claim 14, wherein the battery information further comprises a present battery current, the processing circuit (12) is electrically connected to the power management circuit (14), and the battery detection method further comprises configuring the processing circuit (12) to perform:

determining whether the electronic device (2) is turned off and is connected to the power source (5);

determining whether the current cell voltage of each one of the plurality of batteries (3) is higher than a designated storing voltage in response to determining that the electronic device (2) is turned off and is not connected to the power source (5);

determining whether the present battery current of a battery being not higher than the designated storing voltage is higher than a designated storing current in response to determining that the current cell voltage of any one of the plurality of batteries (3) is not higher than the designated storing voltage; and

controlling the battery to enter a shutdown mode in response to determining that the present battery current of the battery being not higher than the designated storing voltage is higher than the designated storing current.

FIG. 1

S100

battery temperature of any one of batteries is greater than designated temperature?

Y

S101

not adjusting reported battery capacity

N

S102

current cell voltage of any one of batteries is lower than designated voltage?

N

Y

S103

adjusting corresponding current battery capacity to generate reported battery capacity

S104

sending reported battery capacity to operating system executed on electronic device

S105

statistically collecting reported battery capacities respectively corresponding to batteries to obtain total reported battery capacity by operating system

FIG. 2

S100

S200 N

difference between
current fully charged battery capacity and
previous fully charged battery capacity of any one of
batteries exceeds designated fully charged
capacity difference?

N

S101

Y    S201

adjusting corresponding current
battery capacity to generate
reported battery capacity

S104

FIG. 3

S100

N

S300

remaining capacity
of any one of
batteries is zero?

N

S101

Y

S301

adjusting corresponding current
battery capacity to generate
reported battery capacity

S104

FIG. 4

Reported Battery Capacity

— · — · · — · · · — Battery No. 1

— — — — — — — — Battery No. 2

— — · — — Battery No. 3

Battery Capacity

T1  T2  T3

Time

FIG. 5

FIG. 6

S400 → electronic device is turned off and is connected to power source? — N

Y

S401 → current cell voltage of each one of batteries is higher than designated storing voltage? — Y

N

S402 → present battery current is higher than designated storing current? — N

Y

controlling corresponding battery to enter shutdown mode — S403

FIG. 7

Europäisches
Patentamt

European
Patent Office

Office européen
des brevets

# EUROPEAN SEARCH REPORT

**Application Number**

EP 24 20 0496

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2006 038747 A (SANYO ELECTRIC CO) 9 February 2006 (2006-02-09) | 1-4, 8-11,14, 15 | INV. H02J7/00 |
| Y | * paragraph [0004] - paragraph [0029] * | 5-7,12, 13 | |
| X | US 2018/040928 A1 (YU WEN HUAN [TW]) 8 February 2018 (2018-02-08) | 1,10 | |
| Y | * paragraph [0002] - paragraph [0030] * | 5-7,12, 13 | |
| Y | JP 2001 110459 A (NEC MOBILE ENERGY KK) 20 April 2001 (2001-04-20) * paragraph [0006] - paragraph [0018] * | 5,6,12 | |
| Y | US 2014/177145 A1 (KAWAHARA YOUHEI [JP] ET AL) 26 June 2014 (2014-06-26) * paragraph [0072] - paragraph [0073]; figure 1 * | 6,13 | |
| Y | US 2012/004873 A1 (LI GUOXING [US]) 5 January 2012 (2012-01-05) * paragraph [0070] * | 7 | TECHNICAL FIELDS SEARCHED (IPC) H02J |
| A | JP 2010 086764 A (TOSHIBA CORP) 15 April 2010 (2010-04-15) * paragraph [0012] - paragraph [0048] * | 1-15 | |

The present search report has been drawn up for all claims

| Place of search | Date of completion of the search | Examiner |
|---|---|---|
| Munich | 5 March 2025 | Jonda, Sven |

EPO FORM 1503 03.82 (P04C01)

## ANNEX TO THE EUROPEAN SEARCH REPORT
## ON EUROPEAN PATENT APPLICATION NO.

EP 24 20 0496

05-03-2025

| Patent document cited in search report | | Publication date | Patent family member(s) | | Publication date |
|---|---|---|---|---|---|
| JP 2006038747 | A | 09-02-2006 | JP | 4514541 B2 | 28-07-2010 |
| | | | JP | 2006038747 A | 09-02-2006 |
| US 2018040928 | A1 | 08-02-2018 | NONE | | |
| JP 2001110459 | A | 20-04-2001 | NONE | | |
| US 2014177145 | A1 | 26-06-2014 | JP | 6012447 B2 | 25-10-2016 |
| | | | JP | 2014119265 A | 30-06-2014 |
| | | | US | 2014177145 A1 | 26-06-2014 |
| US 2012004873 | A1 | 05-01-2012 | CN | 102315663 A | 11-01-2012 |
| | | | EP | 2403105 A2 | 04-01-2012 |
| | | | JP | 5787581 B2 | 30-09-2015 |
| | | | JP | 2012015094 A | 19-01-2012 |
| | | | TW | 201203779 A | 16-01-2012 |
| | | | US | 2012004873 A1 | 05-01-2012 |
| JP 2010086764 | A | 15-04-2010 | JP | 5329894 B2 | 30-10-2013 |
| | | | JP | 2010086764 A | 15-04-2010 |

EPO FORM P0459